# EUROPEAN PATENT APPLICATION

(11) **EP 1 876 639 A1**
(43) Date of publication of application: **09.01.2008**
(21) Application number: 06731864.2
(22) Date of filing: 14.04.2006
(51) Int. Cl.: H01L 21/205, C23C 16/455, H01L 21/3065, B24B 37/00, B24B 1/04

(54) **SHOWER PLATE AND METHOD FOR MANUFACTURING THE SAME**

(30) Priority: 18.04.2005 JP 2005120256
(71) Applicant: Tokyo Electron Limited (TEL), Tokyo 107-8481 (JP); National University Corporation Tohoku Unversity, Sendai Miyagi 980577 (JP)
(72) Inventor: OKESAKU, Masahiro, 9230852 (JP); OHMI, Tadahiro, Sendai-shi, Miyagi 9800813 (JP)
(74) Representative: Liesegang, Eva
(86) International application number: PCT/JP2006/307928
(87) International publication number: WO 2006/112392

(57) **Abstract**

Disclosed is a shower plate which is formed with a large number of process-gas blowing holes having a simple structure, high machinability and high dimensional accuracy without the risk of unevenness in blowing of a process gas and outbreak of particles, while ensuring constant quality and interchangeability. Through a press forming process, a powder for a ceramic material with a low dielectric constant is formed into a disc-shaped compact having dimensions determined in consideration of a sintering shrinkage value and a machining value. A gas inlet passage 3 and a large number of blowing holes 2 for a compact stage are bored in the disc-shaped compact, and then the disc-shaped compact is sintered. Subsequently, the gas inlet passage 3 and a main hole portion 2b in each of the blowing holes are subjected to grinding to have a surface roughness of 1 s or less. Further, a lapping wire having a taper-shaped end is inserted into an outlet port 2a of the blowing hole 2, and reciprocatingly moved while being slidingly displaced in such a manner that a portion of the lapping wire located in the outlet port 2a is gradually increased in wire diameter, so that the outlet port 2a is lapped to have a diameter of from 0.1 mm to less than 0.3 mm, a dimensional accuracy within ± 0.002 mm, and a surface roughness of 1 s or less.

## Description

### TECHNICAL FIELD

The present invention relates to a shower plate which is used for supplying a process gas uniformly onto a large substrate (wafer) in a semiconductor manufacturing apparatus, and a method of manufacturing the shower plate.

### BACKGROUND ART

Heretofore, in a semiconductor manufacturing process, there have been employed semiconductor manufacturing apparatus such as a CVD apparatus for film-formation and a dry etching apparatus in which a process gas is supplied onto a surface of a wafer.

Such semiconductor manufacturing apparatus are adapted to apply a high-frequency voltage between a wafer and a shower plate from which a process gas is blown out, so as to energize the process gas into a plasma state to form a thin film on a surface of the wafer or etch the wafer surface.

In view of ensuring machinability required for forming a large number of small blowing holes, the shower plate has been formed using a plate of aluminum, silicon or the like. These materials involve problems about difficulty in mirror-finishing inner surfaces of the small blowing holes, and severe wear and tear due to poor corrosion resistance to plasma to be generated from a fluorine or chlorine-based process gas in a reaction space.

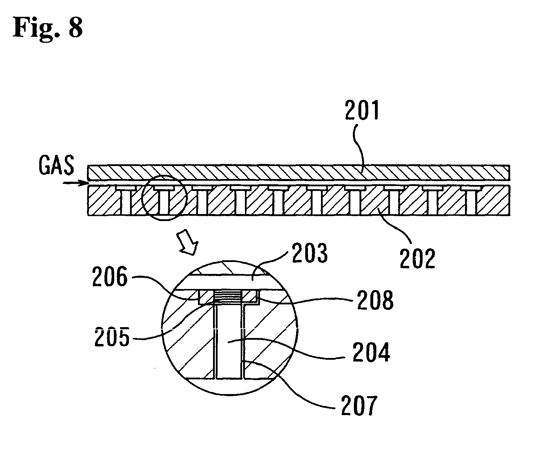

On the above problems, the following Patent Publication 1 discloses a shower plate structure designed to facilitate a formation of blowing holes even using a ceramic material which has difficulty in hole machining. As shown in FIG. 8, a blowing hole 207 is formed as a gap defined between a hole which is bored in a shower plate 202, and a columnar member 204 which is formed to have a diameter less than that of the hole, and inserted into the hole. Specifically, a large number of holes each having a diameter of 2.1 mm are bored in a shower plate 202 having a diameter of 350 mm and a thickness of 20 mm, within a diameter of 200 mm from a center of the shower plate 202, at intervals of 20 mm. Each of the holes has an upper portion formed as an enlarged portion having a depth of 2 mm and a diameter of 6 mm to receive therein an internally-threaded screw 206. A large number of columnar members 204 each having a diameter of 2 mm and one end formed with an external thread 205 are prepared. Each of the columnar members 204 is inserted into a corresponding one of the holes, and fixedly fastened by the internally-threaded screw, wherein a cutout portion 208 pre-formed in the internally-threaded screw 206 is used as a gas passage. Although this shower plate can be made of an appropriately selected material to solve the problem about poor corrosion resistance, it is necessary to bore the large number of holes in the shower plate, and prepare each of the internally-threaded screw and the extemally-thread columnar member in a number equal to that of the holes. This causes considerable increase in production costs. Moreover, the shower plate has difficulty in reducing a frequency of outbreak of particles.

As a shower-plate material having excellent corrosion resistance, high strength and high machinability, the following Patent Publication 2 discloses a ceramic material having a primary crystal phase consisting of a compound of alumina and YAG. This ceramic material comprises alumina and 3 to 50 weight% of YAG, and therefore has both characteristics of alumina, such as high bending strength and high hardness, and characteristics of YAG, such as excellent corrosion resistance. In addition, each of respective average grain sizes of alumina and YAG, a ratio between the average grain sizes, a fracture toughness value of the shower plate and a thermal shock resistance of the shower plate is limited to a specific range. In the Patent Publication 2, it is described that the shower plate with the above characteristics allows a plurality of small holes to be machined with a high degree of accuracy without occurrence of chipping and cracking during machining of fine-holes, outlet ports, etc. However, in order to form the plurality of fine-holes and outlet ports for blowing out gas therefrom, this shower plate is required to employ a process of machining a hole using a fine drill having a desired size or an ultrasonic machining process of gradually drilling a hole while applying ultrasonic vibration to a drilling tool and supplying free abrasive grains thereto. Thus, the drilling tool will be subject to severe wear or abrasion to cause an increase in tool costs, and a process time for machining the large number of fine-holes will be considerably extended. Moreover, this ceramic material is a sintered material having high strength and hardness, and thereby it is extremely difficult to form an ultra-fine outlet port in view of a strength margin of a drilling tool. Thus, due to an inevitable increase in tool diameter, the outlet port must be formed to have a diameter of 0.3 mm or more, which cases a problem about backflow of plasma as a consequent adverse effect. Furthermore, it is extremely difficult to finish the plurality of fine-holes and outlet ports in a desired configuration and a desired dimensional tolerance with a high degree of accuracy.

The following Patent Publication 3 discloses a shower plate formed of a ceramic porous body which contains alumina at a content rate of 99.5 weight% or more and has a porosity of 30 to 65%. Considering that a conventional shower plate has difficulty in uniformly blowing gas in a vacuum chamber due to a gas blowing hole with a predetermined diameter, number, pitch and depth, this shower plate is intended to form pores having an average diameter of 20 to 30 µm in an uniformly distributed manner, so as to allow the pores to serve as gas passages capable of uniformly blowing out a process gas onto a wafer. The shower plate formed of a porous body is manufactured by adding and mixing a resin material to/with alumina at a predetermined ratio to obtain a raw material, forming the raw material into a given shape, and sintering the shaped body. Thus, unevenness in mixing of the resin material and variations in sintering degree and porosity will inevitably occur to cause difficulty in providing a shower plate with stable quality and interchangeability. Moreover, in the shower plate formed of a porous body, grinding chips or fine particles generated during finish machining for outside dimensions will attach to the pores having a complicated configuration to cause a problem about outbreak of particles during an actual operation.
Patent Publication 1: JP 11-297672A
Patent Publication 2: JP 2003-133237A
Patent Publication 3: JP 2003-282462A

### DISCLOSURE OF THE INVENTION

### PROBLEM TO BE SOLVED BY THE INVENTION

It is an object of the present invention to provide a shower plate made of a high-purity material and formed with a large number of process-gas blowing holes having a simple structure and a fine diameter with high dimensional accuracy without the risk of unevenness in blowing of a process gas, outbreak of particles and backflow of plasma, while ensuring constant quality and interchangeability, and a method of manufacturing a shower plate using a high-purity material while allowing a large number of blowing hole to be machined therein with a high degree of accuracy and in an easy manner.

### MEANS FOR SOLVING THE PROBLEM

The present invention provides a shower plate which comprises a disc-shaped plate body; a gas inlet passage including an elongated hole and an opening in communication with said elongated hole, wherein the elongated hole is extended linearly from a side face of said plate body toward a center portion thereof, and the opening is bored in the disc-shaped plate body to extend from an end of the elongated hole to a back surface of the disc-shaped plate body in a direction perpendicular to the elongated hole; and a number of blowing holes for blowing out a process gas therefrom, wherein each of the blowing holes is bored in the disc-shaped plate body from the back surface to a front surface of the disc-shaped plate body. In this shower plate, each of the blowing holes includes a main hole portion and an outlet port which are arranged in communication on the same axis. The outlet port has a diametral dimension of from 0.1 mm to less than 0.3 mm with a dimensional tolerance of the diameter of said outlet port being within ± 0.002 mm.

In the shower plate of the present invention, the dimensional tolerance in the diametral dimension of the outlet port of the blowing hole is preferably within ± 0.001 mm, and a surface roughness of an inner surface of the outlet port is preferably 1.0 s or less, more preferably 0.5 s or less.

According to the present invention, the outlet port in each of the large number of the blowing holes is formed to have a fine diameter with a high degree of accuracy without variation, and therefore a variation in flow rate of a process gas to be blown from the blowing holes can be substantially eliminated. This makes it possible to perform a film-forming operation or an etching operation for a large substrate (wafer) in a uniform or even manner which has not been able to be achieved by conventional shower plates, so as to manufacture high-quality semiconductors free of variation.

Preferably, in the shower plate of the present invention, the disc-shaped plate body is comprised of a ceramic material obtained by sintering a raw powder which is in turn obtained by milling and mixing 95 to 100 mass% of Al₂O₃ fine powder having a purity of 99.95 % or more and an average grain size of 0.8 µm or less, more preferably 0.5 µm or less and 0 to 5 mass% of fine powder having a purity of 99.9% or more and consisting of at least one selected from the group consisting of Y₂0₃, Ce₂0₃ and MgO, forming the raw powder into a given shape, and sintering the obtained compact, wherein the ceramic material has a relative density of 99.4 % or more, or a relative density of 97.5 to 99% and a dielectric loss of 5 × 10⁻³ to 1 × 10⁻⁵.

In this specific embodiment, the high-purity starting powder is prepared and sintered as the ceramic material having a low dielectric loss. Thus, a heat generation due to absorption of microwaves is almost eliminated to provide enhanced transparency to microwaves so as to achieve enhanced plasma generator efficiency and reduced energy less. The relative density may be set at 99.4% or more to provide a dense sintered ceramic material having almost no pore. In this case, a volume of gas to be absorbed therein can be reduced to allow a semiconductor manufacturing apparatus to reach a desired degree of vacuum. Alternatively, the relative density may be set in the range of 97.5 to 99% to leave a given level of pores in the sintered ceramic material. In this case, under conditions where cracks due to thermal shock are highly likely to occur, the pores can prevent crack propagation due to thermal shock.

As to a material for use in the shower plate and the shower-plate manufacturing method of the present invention, an Al₂O₃ fine powder having an average grain size of 0.8 µm or less may be used as a starting powder. This Al₂O₃ fine powder can be sintered at a relatively low temperature to suppress undesirable abnormal grain growth in a crystal structure of the sintered ceramic material. If an Al₂O₃ fine powder having a purity of less than 99.95% is used as the raw powder, impurities will absorb microwaves to hinder transmission of the microwaves, and the dielectric loss will exceed 5 × 10⁻³ to cause undesirable increase in energy loss. Thus, a purity of the raw powder is preferably set at 99.95% or more. 1 mass% or less of the above Al₂O₃ fine powder may be substituted with a high-purity MgO without problems.

Preferably, Y₂O₃, Ce₂O₃ and MgO as a raw powder to be mixed with the Al₂O₃ fine powder is a fine powder which is as fine as possible. This raw powder may have at least an average grain size of 1 µm or less, so that it can be uniformly mixed and dispersed with/in the Al₂O₃ fine powder in the milling/mixing process using a ball mill or the like. Further, the raw powder having a purity of 99.9% can be used to avoid deterioration in dielectric loss.

As to a mixing ratio between the Al₂O₃ fine powder and the Y₂O₃, Ce₂O₃ and/or MgO fine powder, the raw powder for the shower plate may comprise 95 mass % of Al₂O₃ fine powder with the remainder being 5 mass% or less of Y₂O₃, Ce₂O₃ and/or MgO fine powder, to improve a degree of sintering of Al₂O₃ so as to provide enhanced low-temperature sinterability. If the mixing rate of the Y₂O₃, Ce₂O₃ and/or MgO fine powder exceeds 5 mass%, a liquid phase product of the Al₂O₃ and the Y₂O₃, Ce₂O₃ and/or MgO will be excessively increased to cause an increase in grain size of the sintered ceramic material, although the low temperature sinterability will be improved. Moreover, a volume of pores is unexpectedly increased to cause difficulties in controllably sintering the raw powder to have a relative density in an intended range, and in obtaining a dense sintered ceramic material for the shower plate. Thus, in order to allow a sintered ceramic material for the shower plate to have a uniform fine crystal structure and a controlled relative density or high density, the mixing rate of the Y₂O_{3,} Ce₂O₃ and/or MgO fine powder is preferably set at 1 mass% or less. Particularly, when an Al₂O₃ fine powder having an average grain size of 0.5 µm or less is used as the raw powder, excellent low-temperature sinterability can be obtained. Thus, in this case, the mixing rate of the Y₂O_{3,} Ce₂O₃ and/or MgO fine powder may be 0 (zero) mass%, i.e., the Y₂O_{3,} Ce₂O₃ and/or MgO fine powder may not be mixed at all.

The present invention also provides a method of manufacturing the above shower plate which comprises the steps of: forming the above raw powder for the ceramic material into a disc-shaped compact having a configuration determined in consideration of a sintering shrinkage value and a machining value; boring blind holes serving as the main hole portions of the blowing holes, from a back surface of the disc-shaped compact at predetermined positions; boring small holes serving as the outlet ports of the blowing holes, from either side of a front surface or a back surface of the disc-shaped compact, along the axis of each of the blind holes serving as the main hole portions, in such a manner that each of said small holes communicate with each of said blind holes; and thereafter sintering the disc-shaped compact.

In the method of the present invention, in a stage after forming the raw powder for sintering into the disc-shaped compact and before sintering the disc-shaped compact, i.e., when the disc-shaped compact is relatively soft, the main hole portion and the outlet port of the blowing hole are arranged in communication with on the same axis. This can provide enhanced machining efficiency, and reduce wear of drilling tools so as to provide enhanced economic efficiency.

In another aspect, the present invention provides a method of manufacturing the above shower plate which comprises the steps of: forming the above raw powder for the ceramic material into a disc-shaped compact having a configuration determined in consideration of a sintering shrinkage value and a machining value; machining a side face of the disc-shaped compact, using a short drill, to form an inlet of the gas inlet passage; boring an elongated hole, using a long drill, to extend up to a center portion of the disc-shaped compact so as to communicate with the inlet on the same axis thereof, and so as to communicate with an opening bored from the back surface of the disc-shaped compact; and thereafter sintering the disc-shaped compact.

In an operation of forming the gas inlet passage in the shower plate, for example, when the disc-shaped compact obtained from the raw powder to manufacture the shower plate has a post-sintering diametral dimension of 360 mm and a post-sintering thickness dimension of 20 mm, and the gas inlet passage having a pre-sintering diametral dimension corresponding to a post-sintering diametral dimension of 1 mm is formed in the disc-shaped compact, a length of the gas inlet passage is about 200 mm which is one-half of the diameter of the shower plate, i.e., the gas inlet passage has a small diameter and an extremely long length. Thus, during the operation of boring the elongated hole using a long drill, the elongated hole is likely to be offset from an intended axis or curved so as to form micro-cracks or generate a residual stress, in an inner surface of the elongated hole. In this case, the gas inlet passage is highly likely to cause occurrence of sintering cracks during sintering of the disc-shaped compact.

In the above method of the present invention, by use of a short dix, the inlet of the gas inlet passage is firstly bored along an intended axis by a predetermined distance causing no runout. During an operation of boring the elongated hole using a long drill, the inlet effectively serves as a guide hole for the long drill so as to prevent the long hole from being offset from the intended axis.

In yet another aspect, the present invention provides a method of manufacturing the above shower plate which comprises the steps of: inserting a lapping wire having a taper-shaped end portion, into one of the blowing holes of the shower plate comprised of the sintered ceramic material, to penetrate therethrough; and reciprocatingly moving the lapping wire or the shower plate, while slidingly displacing the lapping wire in such a manner that a portion of the lapping wire located in the outlet port of the blowing hole is changed from the end portion toward a base portion of the lapping wire, so as to lap the outlet port of the blowing hole.

In this method of the present invention, the taper-shaped lapping wire is inserted in the blowing hole, and the lapping wire or the shower plate is reciprocatingly moved in a direction parallel to an axis of the blowing hole, while supplying diamond abrasive grains or the like onto the lapping wire. In this manner, the outlet port can be accurately lapped to have a dimensional accuracy within ± 0.002 mm, and a surface roughness of 1 s or less, more preferably 0.5 s or less.

The above shower-plate manufacturing method of the present invention may include the step of, after the step of inserting a lapping wire having a taper-shaped end portion into one of the blowing holes of the shower plate comprised of the sintered ceramic material to penetrate therethrough, clampingly attaching the end portion and the base portion of the lapping wire, respectively, to two rotatable members, in a tensioned manner, wherein the step of reciprocatingly moving the lapping wire or the shower plate includes coaxially rotating the rotatable members having the end and base portions attached thereto, at a same rotational speed.

In this specific embodiment, the taper-shaped lapping wire penetrating through the blowing hole of the shower plate along the axis of the blowing hole is clampingly attached to the upper and lower rotatable members, in a tensioned manner, and the lapping wire or the shower plate is reciprocatingly moved while rotating the lapping wire to lap the outlet port of the blowing hole. Thus, the lapping operation is performed in combined directions of the rotational movement and the upward/downward movement of the lapping wire. This provides enhanced lapping efficiency and surface roughness.

The above shower-plate manufacturing method of the present invention may include the step of, after the step of inserting a lapping wire having a taper-shaped end portion into one of the blowing holes of the shower plate comprised of the sintered ceramic material to penetrate therethrough, fixedly fastening the base portion of the lapping wire to a wire fastening portion of an ultrasonic machining device, in a tensioned manner, wherein the step of reciprocatingly moving the lapping wire or the shower plate includes applying ultrasonic vibration generated by the ultrasonic machining device to the lapping wire in an axial direction of the blowing hole.

In this specific embodiment, the taper-shaped lapping wire penetrating through the blowing hole of the shower plate along the axis of the blowing hole, or the shower plate, is reciprocatingly moved in an upward/downward direction while applying the ultrasonic vibration to the lapping wire in the direction parallel to the axis of the blowing hole. This makes it possible to drastically reduce a process time required for lapping, and lap the outlet port in a dimensional accuracy within ± 0.002 mm.

The above shower-plate manufacturing method of the present invention may include the steps of: after the step of inserting a lapping wire having a taper-shaped end portion into one of the blowing holes of the shower plate comprised of the sintered ceramic material to penetrate therethrough, fixing the end and base portions of the lapping wire in a tensioned manner, respectively, to two arms extending from respective upper and lower portions of a shaft adapted to be moved in an upward/downward direction; and attaching an ultrasonic vibrator to an upper of lower end of the shaft in such a manner as to be located on an axis the shaft, wherein the step of reciprocatingly moving the lapping wire or the shower plate includes applying ultrasonic vibration generated by the ultrasonic vibrator to the lapping wire which is being moved in conjunction with the shaft, in an axial direction of the blowing hole, through the shaft and the arms.

While this method is different from the above specific embodiment in a configuration for applying ultrasonic vibration, an ultrasonic vibration phenomenon acting on the taper shaped lapping wire is the same as that in the above specific embodiment. Further, the lapping operation is performed in the same manner as that in the above specific embodiment. Thus, the same effects as those in the above specific embodiment can be obtained.

The above shower-plate manufacturing method of the present invention may include the step of, after the step of inserting a lapping wire having a taper-shaped end portion into one of the blowing holes of the shower plate comprised of the sintered ceramic material to penetrate therethrough, fastening either one of the end and base portions of the lapping wire to a wire fastening device which is adapted to be rotated and moved in an upward/downward direction, and coupled to an ultrasonic vibrator, wherein the step of reciprocatingly moving the lapping wire or the shower plate includes applying ultrasonic vibration generated by the ultrasonic vibrator, in an axial direction of the blowing hole, and rotation, to the lapping wire through the wire fastening device.

In this specific embodiment, the outlet port is lapped while applying the ultrasonic vibration in the axial direction of the blowing hole and the rotation to the taper-shaped lapping wire penetrating through the blowing hole of the shower plate along the axis of the blowing hole. This makes it possible to provide strong lapping power based on large acceleration generated by the rotation and the ultrasonic vibration, and accurately lap the outlet port in a dimensional accuracy within ± 0.002 mm and a surface roughness of 0.5 s or less.

In the shower-plate manufacturing methods according to the above specific embodiments of the present invention, the operation of lapping the outlet port of the blowing hole after inserting a lapping wire having a taper-shaped end portion into one of the blowing holes of the shower plate comprised of the sintered ceramic material to penetrate therethrough, is performed by reciprocatingly moving the lapping wire or the shower plate, while slidingly displacing the lapping wire in such a manner that a portion of the lapping wire located in the outlet port of the blowing hole is changed from the end portion toward a base portion of the lapping wire.

As above, the lapping operation is performed while slidingly displacing the lapping wire in such a manner that a portion of the lapping wire located in the outlet port of the blowing hole is changed from the end portion toward the base portion of the lapping wire. This makes it possible to drastically reduce a process time required for lapping, and lap the outlet port in a dimensional accuracy within ± 0.002 mm. Further, through improvement in operational accuracy of a lapping apparatus, and appropriately selection of an abrasive grain size, the outlet port can be lapped to achieve a dimensional accuracy within ± 0.001 mm and an inner surface roughness of 0.4 s or less.

In the shower-plate manufacturing methods of the present invention, the lapping may be performed to allow abrasive striations to be formed in an inner surface of the outlet port of the blowing hole in a direction parallel to an axis of the blowing hole.

For example, when the lapping operation for the outlet port is performed by applying a diamond paste having an average grain size of 5 µm, onto the lapping wire, and reciprocatingly moving the lapping wire or the shower plate, the outlet port can be lapped to have an inner surface roughness of 0.5 s or less, and abrasive striations in a direction parallel to the axis of the blowing hole. The abrasive striations serve as a flow-rectifying means to prevent turbulences from occurring in a process gas flow passing though the outlet port at a high speed.

### EFFECT OF THE INVENTION

1. The outlet port of the blowing hole has a diametral dimension of from 0.1 mm to less than 0.3 mm, and the diametral dimension has a dimensional tolerance within ± 0.002 mm. Thus, there is substantially no variation in flow rate of a process gas to be blown out from the large number of blowing holes.
2. The outlet port of the blowing hole has a small diametral dimension of from 0.1 mm to less than 0.3 mm. Thus, backflow of plasma can be prevented.
3. A film-forming operation or an etching operation can be performed for a large substrate (wafer) in a uniform or even manner which has not been able to be achieved by conventional shower plates, so as to manufacture high-quality semiconductors.
4. The blowing hole can have an inner surface with a surface roughness of 0.5 s or less. Thus, a flow resistance of a process gas to be blown out can be reduced.
5. The blowing hole of the shower plate is lapped using the lapping wire having a taper-shaped end portion. This makes it possible to provide the blowing hole with high degree of accuracy, and stably manufacture shower plates having no variation in flow rate of a process gas to be blown out from the large number of blowing holes, i.e., having interchangeability.
6. The material of the shower plate has a high purity, and an excellent dielectric loss of 5 × 10⁻³ to 1 × 10⁻⁵. Thus, the shower plate can exhibit excellent transparency to microwave and low energy loss.
7. The blowing hole is bored from the back surface to the front surface of the disc-shaped plate body. Thus, the blowing hole itself has a simple structure and therefore can be machined and formed in an easy manner.
8. The gas inlet passage and the blowing holes are formed in the pre-sintering stage of the disc-shaped compact. This makes it possible to significantly reduce wear/abrasion of drilling tools and drastically reduce a process time required for boring the holes.
9. The ceramic material having a low dielectric constant can be sintered to have a relative density of 99.4% or more, and the both surfaces of the shower plate and the inner surface of the blowing hole can have a surface roughness of 1 s or less, more preferably 0.5 s or less. This makes it possible to prevent breakout of particles.
10. The shower plate may be controllably sintered to have a relative density of 97.5% to 99%. This shower plate is suitably used under conditions where cracks due to thermal shock are highly likely to occur.
11. Either one or both of rotation and ultrasonic vibration may be applied to the lapping wire. This makes it possible to provide enhanced blowing hole lapping efficiency.
12. Abrasive striations are formed in an inner surface of the outlet port of the blowing hole in a direction parallel to the axis of the blowing hole. The abrasive striations do not generate turbulences in a process gas to be blown out, but rather serve as a flow-rectifying means.

### BEST MODE FOR CARRYING OUT THE INVENTION

With reference to the accompanying drawings, an embodiment of the present invention will now be described below. The following embodiment disclosed in the accompanying drawings is illustrative only, and various other structures/configurations and machining/manufacturing processes may be appropriately combined therewith without departing from the spirit and scope of the present invention.

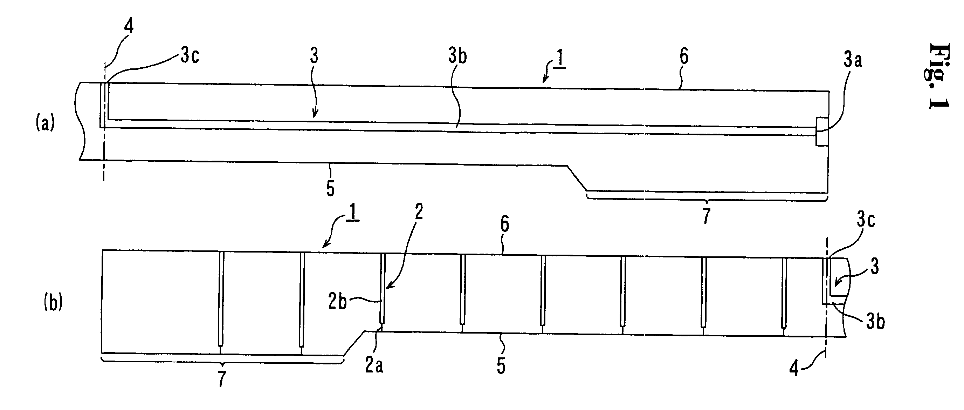

FIG. 1 is a schematic diagram showing a shower plate according to one embodiment of the present invention, wherein FIG. 1 (a) is a vertical sectional view of an approximately half portion of the shower plate where a gas inlet passage 3 is formed, taken along an axis of the gas inlet passage 3, and FIG. 1 (b) is a vertical sectional view of an approximately half portion of the shower plate where the gas inlet passage 3 is not formed, taken along a direction from a center 4 to an outer peripheral edge of the shower plate across respective axes of a plurality of blowing holes 2.

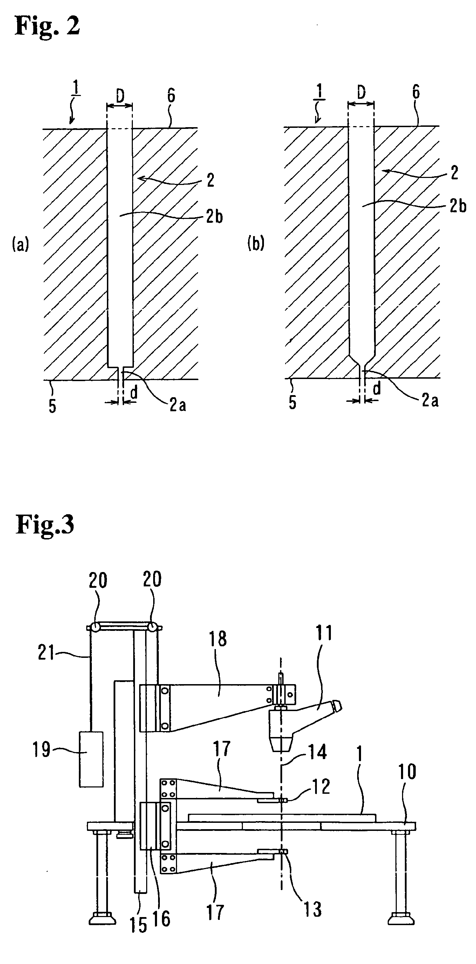

As shown in FIG. 1, a disc-shaped shower plate 1 has a front surface (lower surface in FIGS. 1 and 2) 5 where a region except an outer peripheral region 7, i.e., a region inside an inner concentric circle of the outer peripheral region 7, is formed as a concave surface. Although can not seen in FIG. 1 (a), the half portion in FIG. 1 (a) is formed with a plurality of blowing holes in the same manner as that in FIG. 1(b).

FIG. 2 is a schematic enlarged view showing an example of the blowing hole 2 illustrated in FIG. 1(b). The blowing hole 2 comprises a main hole portion 2b and an outlet port 2a. The main hole portion 2b is formed to have a diameter D and extend from a back surface (upper surface in FIGS. 1 and 2) 6 of the shower plate 1 to a position adjacent to the front surface 5 of the shower plate 1 in a direction perpendicular to the back and front surfaces 6, 5. The outlet port 2a is formed to have a diameter d and extend from a center of an end portion of the main hole portion 2b with the diameter D to the front surface 5. That is, the main hole portion 2b and the outlet port 2a are arranged in communication on the same axis. FIG. 2(a) shows one example where the end portion of the main hole portion 2b with the diameter D is formed as a right-angled end, and FIG. 2 (b) shows another example where the end portion of the main hole portion 2b is formed as a conical-shaped (i.e., tapered) end.

As shown in FIG. 2, the diameter d of the outlet port 2a of the blowing hole 2 is set at a smaller value than that of the diameter D of the main hole portion 2b. This makes it possible to significantly reduce a pressure loss in the main hole portion 2b of the blowing hole 2, and accelerate a flow of a process gas in the outlet port 2a so as to eliminate the risk of backflow of plasma.

In this embodiment, the diameter D of the main hole portion 2b of the blowing hole 2 is set at 1 mm and the diameter d of the outlet port 2a is set at 0.1mm. An inner surface of the blowing hole 2 including the outlet port 2a is subjected to grinding to have a surface roughness of 0.5 s or less. The inner surface of the outlet port 2a is further subjected to wire-lapping using an after-mentioned taper-shaped lapping wire, to have a dimensional accuracy of φ d within ± 0.002 mm, more preferably within ± 0.001 mm. The shower plate 1 subjected to the above finish machining can ensure constant quality without variation in quality, where a process gas is blown from each of the large number of blowing holes 2 at substantially the same flow rate.

As shown in FIG. 1 (a), a gas inlet passage 3 for introducing a process gas into a space facing the back surface 6 of the shower plate 1 comprises an elongated hole 3b and an opening 3c in communication with the elongated hole 3b. The elongated hole 3b is bored to extend linearly from an inlet 3a formed in one side region of a circumferential surface of the shower plate 1 to a center 4 of the shower plate 1. The opening 3c is bored to extend from an end portion of the elongated hole 3b to the back surface 6 of the shower plate 1 in a direction perpendicular to the elongated hole 3b. An inner surface of the gas inlet passage 3 can be subjected to grinding to have a surface roughness of 0.5 s or less so as to significantly reduce a flow resistance of the process gas.

FIG. 3 is a schematic diagram of a wire-lapping apparatus for use in subjecting the outlet port 2a of the blowing hole 2 to lap finishing. In FIG. 3, the shower plate 1 is placed on a base 10 having a bored central portion. Under observation using a centering microscope 11, the shower plate 1 is slidingly displaced by operator's hands in desired directions in such a manner that a central axis of the outlet port 2a of a selected one of the blowing holes 2 illustrated in FIG. 1(b) is aligned with a guide holder 12 and a wire guide 13. In the aligned state, the shower plate 1 is fixed to the base 10. Then, a wire 14 having a taper-shaped end is inserted into the selected blowing hole 2 to penetrate therethrough, and fixed to respective mounting portions of the guide holder 12 and the wire guide 13. Each of the guide holder 12 and the wire guide 13 is attached to a hanger 17 coupled to a slidable block 16 adapted to be slidingly moved along a slide rail 15. A bracket 18 is connected to a weight 19 by a rope 21 through a roller 20. The weight 19 can be moved upwardly and downwardly to allow the taper-shaped wire 14 coated or supplied with diamond abrasive-grains to be reciprocatingly moved in an upward/downward direction within the selected blowing hole 2. Specifically, the wire 14 having the taper-shaped end is reciprocatingly moved in an axial direction of the selected blowing hole 2, while being slidingly displaced in such a manner that a portion of the taper-shaped end located in the outlet port 2a of the selected blowing hole 2 is gradually increased in wire diameter, and finally a straight (i.e., non-tapered) portion of the wire 14 is located in the outlet port 2a. In this manner, each of the blowing holes 2 can be lapped to allow the outlet port 2a to have a dimensional accuracy within ± 0.002 mm and higher dimensional accuracy within ± 0.001 mm, and allow the inner surface of the blowing hole to have a surface roughness of 0.5 s or less.

In the above embodiment, the shower plate 1 is fixed, and the wire 14 having the taper-shaped end is reciprocatingly moved in the axial direction of the blowing hole 2. Alternatively, the wire-lapping operation may be performed under the condition that the taper-shaped wire 14 penetrating through the blowing hole 2 is fixed, and the shower plate 1 is reciprocatingly moved in an upward/downward direction. As above, the wire 14 is reciprocatingly moved in a direction parallel to the axis of the blowing hole 2 within the outlet port 2a of the blowing hole. Thus, abrasive striations in the inner surface of the outlet port 2a will be formed in a direction parallel to the axis of the blowing hole 2.

Although an apparatus for forming an end of a wire into a taper shape is not illustrated, the end of the wire may be formed into a taper shape in the following manner. Firstly, a wire is placed on an upwardly-facing surface of a first plate or grindstone reciprocatable in a lateral direction, to extend in a direction perpendicular to the reciprocating direction of the first plate or grindstone, and a second plate or grindstone having a downwardly-facing surface is disposed to be imposed on the wire at a predetermined pressure. The downwardly-facing surface of the second plate or grindstone has a lateral axis parallel to the upwardly-facing surface of the first plate or grindstone, and a longitudinal axis inclined relative to the upwardly-facing surface of the first plate or grindstone. Thus, the first grindstone having the upwardly-facing surface can be reciprocatingly moved in the lateral direction to prepare a wire having a taper-shaped end. When the two plates having the upwardly-facing and downwardly-facing surfaces are used in place of the grindstones, abrasive grains can be supplied to the surfaces of the plates during a reciprocating movement of the first plate to prepare a wire having a taper-shaped end.

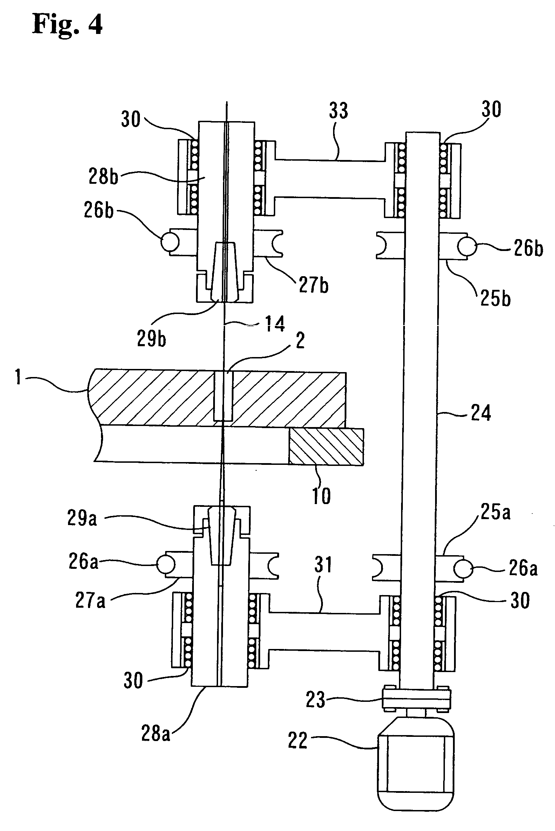

FIG. 4 is a vertical sectional view showing a lapping apparatus designed to give a rotational movement to a lapping wire. In the lapping apparatus illustrated in FIG. 4, a first pulley 25a and a second pulley 25b are fixed onto a rotary shaft 24 coupled to a reduction-gear motor (i.e., motor with a reduction gear mechanism) 22 through a coupling flange 23, and a first belt 26a and a second belt 26b are attached to the first pulley 25a and the second pulley 25b, respectively. A torque is transmitted from each of to a corresponding one of the first pulley 25a and the second pulley 25b to a corresponding one of a third pulley 27a and a fourth pulley 27b through a corresponding one of the first belt 26a and the second belt 26b, so as to rotate first and second rotatable members 28a, 28b at an identical rotational speed.

First and second collets 29a, 29b are attached, respectively, to the first and second rotatable members 28a, 28b, in such a manner as to allow a lapping wire 14 penetrating through one of the blowing holes 2 of the shower plate 1, to be fastened in a tensioned manner. In this state, the shower plate 1 is reciprocatingly moved in an upward/downward direction together with a base 10, or the entire rotating mechanism, i.e., the lapping wire 14, is reciprocatingly moved in the upward/downward direction, while slidingly displacing the lapping wire 14 in such a manner that a portion of the lapping wire 14 located in the outlet port 2a of the blowing hole 2 is changed from an end portion toward a base portion thereof, so as to efficiently lap the outlet port 2a based on the rotating lapping wire 14 coated or supplied with abrasive grains.

The reference numeral 30 in FIG. 4 indicates a linear ball bearing. Although not illustrated in FIG. 4, the mechanism, such as the guide holder 12 and/or the wire guide 13, as shown in FIG. 3, is preferably used in combination.

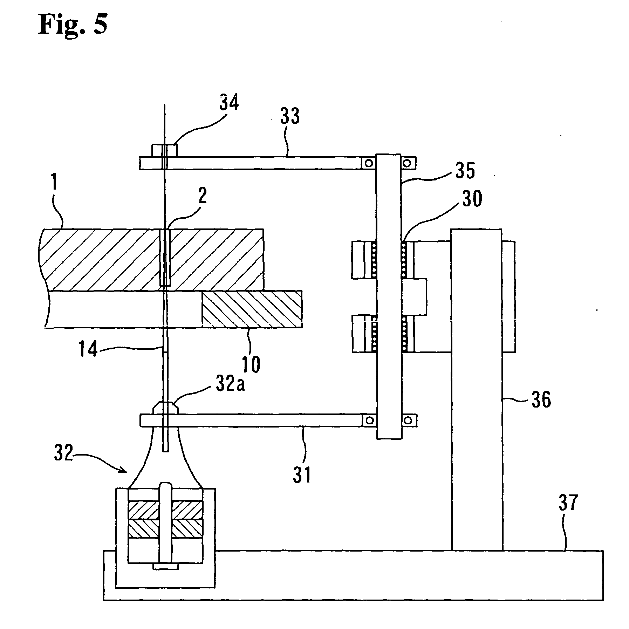

FIG. 5 is a vertical sectional view showing a lapping apparatus designed to give ultrasonic vibration to a lapping wire. In the lapping apparatus illustrated in FIG. 5, a base portion of a lapping wire 14 penetrating through one of the blowing holes 2 of the shower plate 1 is fastened to a collet 32a (wire fasten portion) of an ultrasonic vibrator 32 fastened to a lower arm 31, and an end portion of the lapping wire 14 is fastened by a wire fastening device 34 attached to an upper arm 33, in a tensioned manner, so as to apply ultrasonic vibration generated by the ultrasonic vibrator 32 to the lapping wire 14 in an axial direction of the blowing hole 2. Each of the upper arm 33 and the lower arm 31 is attached to a shaft 35 which is attached to a supporting column 36 through a linear ball bearing 30, in an upwardly/downwardly movable manner, so that the ultrasonic vibration generated by the ultrasonic vibrator 32 is also transmitted to the upper arm 33, the lower arm 31 and the shaft 35 so as to prevent vibration in the lapping wire 14 from being restrained.

In this lapping apparatus, a base plate 37 is reciprocatingly moved in an upward/downward direction (i.e., the lapping wire 14 is reciprocatingly moved), or the shower plate 1 is reciprocatingly moved in the upward/downward direction together with a base 10, while slidingly moving the lapping wire 14 in such a manner that a portion of the lapping wire 14 is located in the lapping wire 14 of the blowing hole 2 is changed from the end portion toward the base portion thereof, so as to lap the outlet port 2a.

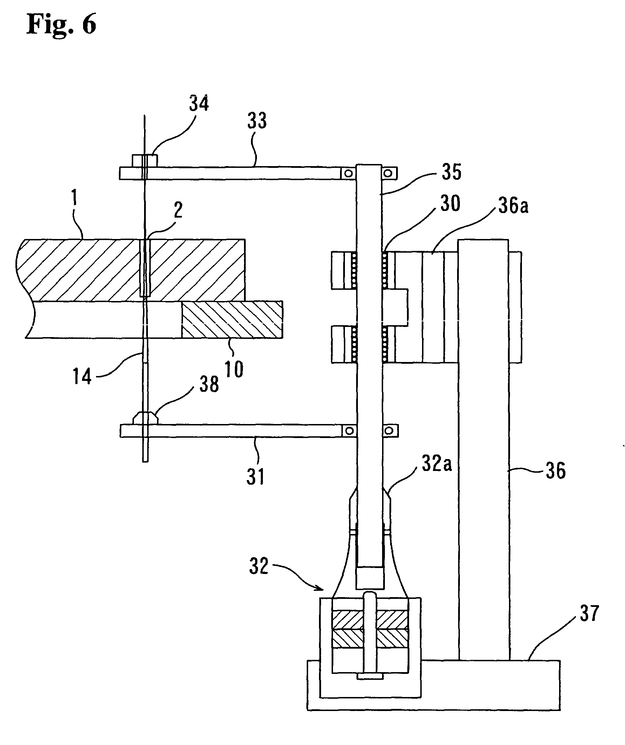

FIG. 6 a vertical sectional view showing another lapping apparatus designed to give ultrasonic vibration to a lapping wire. In the lapping apparatus illustrated in FIG. 6, a shaft 35 attached to an arm 36a of a supporting column 36 through a linear ball bearing 30, in an upwardly/downwardly movable manner, is fastened to a collet 32a of an ultrasonic vibrator 32. A lapping wire 14 penetrating through one of the blowing holes 2 of the shower plate 1 is fastened to an upper arm 33 and a lower arm 31 each extending from the shaft 35, respectively, by use of a wire fastening device 34 and a collet 38, in a tensioned manner, so as to transmit ultrasonic vibration generated by the ultrasonic vibrator 32 to the lapping wire 14 in the axial direction the blowing hole 2.

In this lapping apparatus, a base plate 37 is reciprocatingly moved in an upward/downward direction (i.e., the lapping wire 14 is reciprocatingly moved), or the shower plate 1 is reciprocatingly moved in the upward/downward direction together with a base 10, while slidingly moving the lapping wire 14 in such a manner that a portion of the lapping wire 14 located in the outlet port 2a of the blowing hole 2 is changed from the end portion toward the base portion thereof, so as to lap the outlet port 2a, in the same manner as that in the lapping apparatus illustrated in FIG. 5.

Although not illustrated in FIGS. 5 and 6, the mechanism, such as the guide holder 12 and/or the wire guide 13, as shown in FIG. 3, is preferably used in combination.

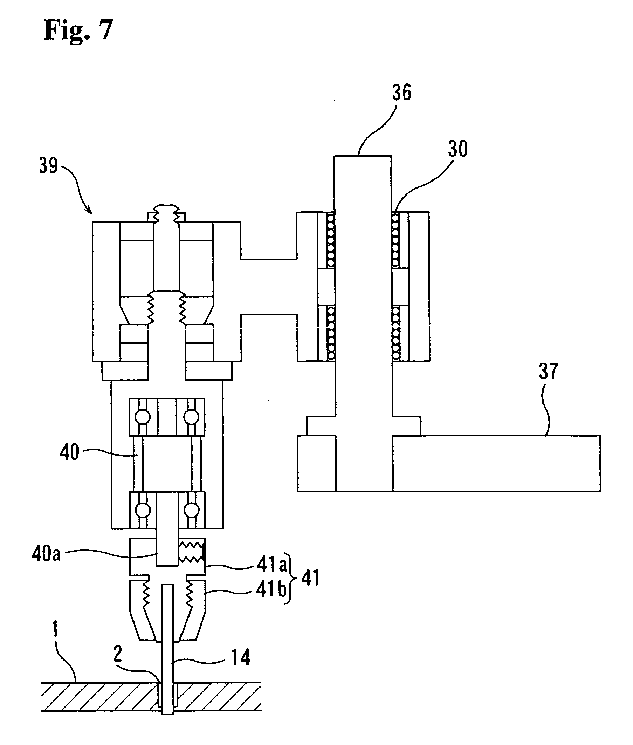

FIG. 7 a vertical sectional view showing a lapping apparatus designed to give a rotational movement and an ultrasonic vibration to a lapping wire. In the lapping apparatus illustrated in FIG. 7, a wire fastening device 41 comprising a collet 41a and a collet nut 41b is attached to a rotary shaft 40a of a micro-motor 40 coaxially assembled to a motor-directly-coupled ultrasonic vibrator 39, and a base portion of a lapping wire 14 penetrating through one of the blowing holes 2 of the shower plate 1 is fastened by the wire fastening device 41, while allowing an end portion of the lapping wire 14 to be a free end.

In this lapping apparatus, the motor-directly-coupled ultrasonic vibrator 39 is coupled to a supporting column 36 through a linear ball bearing 30. The outlet port of the blowing hole 2 is reciprocatingly moved in an upward/downward direction while applying rotation and axial ultrasonic vibration to the lapping wire 14, so as to lap the outlet port 2a of the blowing hole 2.

### EXAMPLE

A specific example of the shower plate of the present invention and a manufacturing method therefor will be described with reference to FIG. 1.

A raw powder for sintering prepared by mixing an Y₂O₃ fine powder having a purity of 99.9% or more with an Al₂O₃ fine powder having a purity of 99.95% or more, in an amount of 0.1 to 5 mass%, was formed through a Cold Isostatic Press (CIP) to obtain a disc-shaped compact having a configuration determined in consideration of a sintering shrinkage value (i.e., a value of shrinkage due to sintering) and a machining value (i.e., a value to be machined). After machining one side region of a circumferential surface of the disc-shaped compact toward a center of the disc-shaped compact using a short drill having a diameter corresponding to that (φ 1 mm) of the gas inlet passage 3 of the finished shower plate, to form an inlet 3a, an elongated hole 3b was bored along an axis of the inlet 3a to extend up to the center of the disc-shaped compact, using a long drill. In this manner, the short and long drills were used in combination so that the elongated hole 3b of the gas inlet passage 3 could be formed in such a manner as to allow each of a coaxiality and a straightness thereof to be 0.002 mm or less.

Then, an opening 3c was bored from a central region of a back surface 6 of the disc-shaped compact, using a short drill having the same size as that of the above short drill, to provide communication with an end portion of the elongated hole 3b. Alternatively, after boring the opening 3c, the elongated hole 3b may be bored to extend up to the center of the disc shaped compact so as to provide communication between the inlet 3a and the opening 3c.

Further, a blind hole was bored from the back surface 6 toward a front surface 5 of the disc-shaped compact to extend up to a position which allows the outlet port 2a of the blowing hole 2 of the finished shower plate to have a length of 0.5 mm, using a drill having a size which allows the main hole portion 2b of the blowing hole 2 of the finished shower plate to have a diameter D of 1 mm.

Then, an outlet port 2a was bored from the front surface 5 or from the side of the back surface 6 of the disc-shaped compact along an axis of the blind hole, using a small-size drill which allows the outlet port 2a of the blowing hole 2 of the finished shower plate to have a diameter d of 0.1 mm, to establish communication of the blowing hole 2.

The above disc-shaped compact formed with the gas inlet passage and a large number of the blowing holes 2 was sintered in a conventional manner, and then subjected to a Hot Isostatic Press (HIP), to obtain a dense shower-plate sintered material having a relative density of 99.4% or more, more preferably 99.5 % or more, and a dielectric loss of 5 × 10⁻³ to 1 × 10-⁵.

The front and back surface or an entire outer peripheral surface of the sintered material was subjected to grinding and abrasive finishing, using a diamond grindstone and diamond abrasive grains, in such a manner as to have a surface roughness of 1 s or less, more preferably 0.5 s or less.

Then, in order to subject the gas inlet passage 3 having a diameter of 1 mm to abrasive finishing, a mandrel having a base portion with a diameter of 0.9 mm, and an end portion with a length of 10 mm, a diameter of 0.990 mm and at least one slit, more preferably two slits, for dividing the end portion into equal portions around an axis of the mandrel, was prepared. A diamond paste having an abrasive grain size of 5 µm was applied on the divided portions of the end portion of the mandrel, and the mandrel was inserted into the gas inlet passage 3 along its axis while being rotated at a high speed. According to the high-speed rotation, a diameter of the divided portions of the end portion of the mandrel is increased by a centrifugal force to generate a grinding force. In this manner, the abrasive finishing was carried out to allow the gas inlet passage 3 to have a surface roughness of 1 s or less, more preferably 0.5 s or less.

The following description will be made about an abrasive finishing for the blowing hole 2. In the sintered material of this example, a diametral dimension of the main body portion 2b of the blowing hole 2 was set in the range of 0.995 to 1.00 mm, and a diametral dimension of the outlet port 2a of the blowing hole 2 was set in the range of 0.093 to 0.098 mm.

In the abrasive finishing for the main body portion 2b of the blowing hole 2, a diamond paste having an abrasive grain size of 5 µm was applied on a mandrel having the same size as that of the aforementioned mandrel, and the mandrel was inserted into the blowing hole 2 along its axis while being rotated at a high speed, so as to allow the main body portion 2b of the blowing hole 2 to have a diameter D of 1.0 mm and a dimensional accuracy within ± 0.002 mm.

Further, in order to lap the outlet port 2a of the blowing hole 2, a lapping wire was prepared in such a manner that it has a diametral dimension of 0.093 mm and an overall length 200 mm, and an end portion thereof having a length of 100 mm is machined into a taper shape to provide an end edge with a diametral dimension of 0.08 mm.

Then, the shower-plate sintered material subjected to the above machining and finishing was attached to the wire-lapping apparatus illustrated in FIG. 3. The end portion of the prepared lapping wire 14 was inserted into the outlet port 2a of the blowing hole 2, and the lapping wire 14 was reciprocatingly moved in the axial direction of the outlet port 2a while supply diamond abrasive grains having an average grain size of 4 µm onto the lapping wire 14. During this operation, the lapping wire 14 was slidingly moved in such a manner that a portion of the lapping wire 14 located in the outlet port 2a is gradually increased in wire diameter, and finally the outlet port 2a is reciprocatingly lapped by a base portion of the lapping wire 14 having a diametral dimension of 0.093 mm. In this manner, the outlet port 2a of each of the blowing holes 2 was lapped to have a diametral dimension d within 0.1 ± 0.001 mm.

A surface roughness of the portion subjected to the abrasive finishing was measured. As a result, each of the gas inlet passage 3 and the main hole portion 2b of the blowing hole 2 had a surface roughness of 0.5 s or less, and the outlet port 2a of the blowing hole 2 had a surface roughness of 0.4 s or less. Due to the reciprocating movement of the lapping wire 14 in the axial direction of the blowing hole 2, abrasive striations were formed in an inner surface of the outlet port 2a to extend in a direction parallel to the axis of the blowing hole 2.

Further, a lapping operation for the outlet port 2a of the blowing hole 2 was also carried out using each of the wire-lapping apparatuses illustrated in FIGS. 4 to 7. As a result, in either case, the outlet port 2a of the blowing hole 2 had a diametral dimension within 0.1 ± 0.001 mm. In addition, a surface roughness of 0.4 s or less could be achieved when diamond abrasive grains having an average grain size of 4 µm were supplied onto the lapping wire 14.

As a final treatment, the shower plate subjected to the grinding and abrasive finishing was subjected to a precision ultrasonic cleaning process to fully remove fine particles and contaminants attached or fixed on each portion. Finally, a finished shower plate free of breakout of particles could be obtained.

### INDUSTRIAL APPLICABILITY

The present invention can be applied to a shower plate for use in a semiconductor manufacturing apparatus, such as a CVD apparatus or a dry etching apparatus.

### BRIEF DESCRIPTION OF DRAWINGS

FIG. 1 shows a shower plate according to one embodiment of the present invention, wherein (a) is a vertical sectional view of an approximately half portion of the shower plate where a gas inlet passage is formed, and (b) is a vertical sectional view of an approximately half portion of the shower plate where the gas inlet passage 3 is not formed, taken along a plurality of blowing holes.
FIG. 2 is an enlarged view showing an example of the blowing hole illustrated in FIG. 1 (b), wherein (a) shows one example where an end portion of a main hole portion of the blowing hole is formed as a right-angled end, and (b) shows another example where the end portion of the main hole portion of the blowing hole is formed as a tapered end.
FIG. 3 is a schematic diagram of a wire-lapping apparatus for use in the present invention.
FIG. 4 is a vertical sectional view showing a lapping apparatus designed to give a rotational movement to a lapping wire.
FIG. 5 is a vertical sectional view showing a lapping apparatus designed to give ultrasonic vibration to a lapping wire.
FIG. 6 a vertical sectional view showing another lapping apparatus designed to give an ultrasonic vibration to a lapping wire.
FIG. 7 a vertical sectional view showing a lapping apparatus designed to give a rotational movement and ultrasonic vibration to a lapping wire.
FIG. 8 is a vertical sectional view showing one example of a conventional shower plate.

### EXPLANATION OF CODES

- 1:: shower plate
- 2:: blowing hole
- 2a:: outlet port of blowing hole
- 2b:: main hole portion of blowing hole
- 3:: gas inlet passage
- 3a:: inlet of gas inlet passage
- 3b:: elongated hole of gas inlet passage
- 3c:: opening of gas inlet passage
- 4:: center of shower plate
- 5:: front surface of shower plate
- 6:: back surface of shower plate
- 7:: outer peripheral region of shower plate
- 10:: base
- 11:: centering microscope
- 12:: guide holder
- 13:: wire guide
- 14:: wire (lapping wire)
- 15:: slide rail
- 16:: slidable block
- 17:: hanger
- 18:: bracket
- 19:: weight
- 20:: roller
- 21:: rope
- 22:: reduction-gear motor
- 23:: coupling flange
- 24:: rotary shaft
- 25a, 25b:: pulley
- 26a, 26b:: belt
- 27a, 27b:: pulley
- 28a, 28b:: rotatable member
- 29a, 29b:: collet
- 30:: linear ball bearing
- 31:: lower arm
- 32:: ultrasonic vibrator
- 32a:: collet
- 33:: upper arm
- 34:: wire fastening device
- 35:: shaft
- 36:: supporting column
- 37:: base plate
- 38:: collet
- 39:: motor-direly-coupled ultrasonic vibrator
- 40:: micro-motor
- 40a:: rotary shaft
- 41:: wire fastening device
- 41a:: collet
- 41b:: collet nut
- 201:: gap-defining plate (cover plate)
- 202:: shower plate
- 203:: gap
- 204:: columnar member
- 205:: external thread
- 206:: internally-threaded screw
- 207:: blowing hole
- 208:: cutout

## Claims

1. A shower plate comprising:
a disc-shaped plate body;
a gas inlet passage including an elongated hole and an opening in communication with said elongated hole, said elongated hole being extended linearly from a side face of said plate body toward a center portion thereof, said opening being bored in said disc-shaped plate body to extend from an end of said elongated hole to a back surface of said disc-shaped plate body in a direction perpendicular to said elongated hole; and
a number of blowing holes for blowing out a process gas therefrom, each of said blowing holes being bored in said disc-shaped plate body from said back surface to a front surface of said disc-shaped plate body,
wherein each of said blowing holes includes a main hole portion and an outlet port which are arranged in communication on the same axis, said outlet port having a diametral dimension of from 0.1 mm to less than 0.3 mm with a dimensional tolerance of the diameter of said outlet port being within ± 0.002 mm.

2. The shower plate as defined in claim 1, wherein said disc-shaped plate body is comprised of a ceramic material obtained by sintering a raw powder which is in turn obtained by milling and mixing 95 to 100 mass% of Al₂O₃ fine powder having a purity of 99.95 % or more and 0 to 5 mass% of fine powder having a purity of 99.9% or more and consisting of at least one selected from the group consisting of Y₂0₃, Ce₂0₃ and MgO, said ceramic material having a relative density of 99.4% or more and a dielectric loss of 5 × 10⁻³ to 1 × 10⁻⁵.

3. The shower plate as defined in claim 1, wherein said disc-shaped plate body is comprised of a ceramic material obtained by sintering a raw powder which is in turn obtained by milling and mixing 95 to 100 mass % of Al₂O₃ fine powder having a purity of 99.95% or more and 0 to 5 mass% of fine powder having a purity of 99.9% or more and consisting of at least one selected from the group consisting of Y₂0₃, Ce₂0₃ and MgO, said ceramic material having a relative density of 97.5 to 99% and a dielectric loss of 5 × 10⁻³ to 1 × 10⁻⁵.

4. A method of manufacturing the shower plate as defined in any one of claims 1 to 3, comprising the steps of:
inserting a lapping wire having a taper-shaped end portion, into one of the blowing holes of the shower plate comprised of the sintered ceramic material; and
reciprocatingly moving said lapping wire or said shower plate while slidingly displacing said lapping wire in such a manner that a portion of said lapping wire located in the outlet port of said blowing hole is changed from said end portion toward a base portion of said lapping wire, so as to lap said outlet port of said blowing hole.

5. The method as defined in claim 4, which includes the steps of:
forming the raw powder for said ceramic material into a disc-shaped compact having a configuration determined in consideration of a sintering shrinkage value and a machining value;
boring blind holes serving as the main hole portions of said blowing holes, from a back surface of said disc-shaped compact at predetermined positions;
boring small holes serving as the outlet ports of said blowing holes, from either side of a front surface or a back surface of said disc-shaped compact along the axis of each of said blind holes serving as said main hole portions, in such a manner that each of said small holes communicate with each of said blind holes; and
thereafter sintering said disc-shaped compact.

6. The method as defined in claim 4, which includes the steps of:
forming the raw powder for said ceramic material into a disc-shaped compact having a configuration determined in consideration of a sintering shrinkage value and a machining value;
machining a side face of said disc-shaped compact, using a short drill, to form an inlet of the gas inlet passage;
boring an elongated hole, using a long drill, to extend up to a center portion of said disc-shaped compact so as to communicate with said inlet on the same axis thereof, and so as to communicate with an opening bored from said back surface of said disc-shaped compact; and
thereafter sintering said disc-shaped compact.

7. The method as defined in claim 4, which includes the step of, after said step of inserting a lapping wire having a taper-shaped end portion into one of the blowing holes of the shower plate comprised of the sintered ceramic material to penetrate therethrough, clampingly attaching the end portion and the base portion of said lapping wire, respectively, to two rotatable members, in a tensioned manner, wherein said step of reciprocatingly moving the lapping wire or the shower plate includes coaxially rotating said rotatable members having said end and base portions attached thereto, at a same rotational speed.

8. The method as defined in claim 4, which includes the step of, after said step of inserting a lapping wire having a taper-shaped end portion into one of the blowing holes of the shower plate comprised of the sintered ceramic material to penetrate therethrough, fixedly fastening the base portion of said lapping wire to a wire fastening portion of an ultrasonic machining device, in a tensioned manner, wherein said step of reciprocatingly moving the lapping wire or the shower plate includes applying ultrasonic vibration generated by said ultrasonic machining device to said lapping wire in an axial direction of said blowing hole.

9. The method as defined in claim 4, which includes the steps of;
after said step of inserting a lapping wire having a taper-shaped end portion into one of the blowing holes of the shower plate comprised of the sintered ceramic material to penetrate therethrough,
fixing the end and base portions of said lapping wire in a tensioned manner, respectively, to two arms extending from respective upper and lower portions of a shaft adapted to be moved in an upward/downward direction; and
attaching an ultrasonic vibrator to an upper of lower end of said shaft in such a manner as to be located on an axis said shaft,
wherein said step of reciprocatingly moving the lapping wire or the shower plate includes applying ultrasonic vibration generated by said ultrasonic vibrator to said lapping wire which is being moved in conjunction with said shaft, in an axial direction of said blowing hole, through said shaft and said arms.

10. The method as defined in claim 4, which includes the step of, after said step of inserting a lapping wire having a taper-shaped end portion into one of the blowing holes of the shower plate comprised of the sintered ceramic material to penetrate therethrough, fastening either one of the end and base portions of said lapping wire to a wire fastening device which is adapted to be rotated and moved in an upward/downward direction, and coupled to an ultrasonic vibrator,
wherein said step of reciprocatingly moving the lapping wire or the shower plate includes applying ultrasonic vibration generated by said ultrasonic vibrator, in an axial direction of said blowing hole, and rotation, to said lapping wire through said wire fastening device.

11. The method as defined in claim 4, wherein said lapping is performed to allow abrasive striations to be formed in an inner surface of said outlet port of said blowing hole in a direction parallel to an axis of said blowing hole.
